# EUROPÄISCHE PATENTSCHRIFT

(11) **EP 1 432 995 B1**
(45) Veröffentlichungstag und Bekanntmachung des Hinweises auf die Patenterteilung: **25.05.2005**
(21) Anmeldenummer: 02774331.9
(22) Anmeldetag: 11.09.2002
(51) Int. Cl.: G01R 31/3185

(54) **REMOTE-PROGRAMMIERUNG VON PLD BAUSTEINEN VIA BOUNDARY SCAN IM SYSTEM**
REMOTE-PROGRAMMING OF PLD MODULES VIA BOUNDARY SCAN IN THE SYSTEM
PROGRAMMATION A DISTANCE DE COMPOSANTS PLD PAR BALAYAGE PERIPHERIQUE DANS LE SYSTEME

(30) Priorität: 28.09.2001 DE 10147891
(43) Veröffentlichungstag der Anmeldung: 30.06.2004
(73) Patentinhaber: SIEMENS AKTIENGESELLSCHAFT, 80333 München (DE)
(72) Erfinder: OTTE, Gerhard, 82515 Wolfratshausen (DE)
(86) Internationale Anmeldenummer: PCT/DE2002/003382
(87) Internationale Veröffentlichungsnummer: WO 2003/031997

(56) Entgegenhaltungen:
- US-A- 5 056 093
- US-A- 5 640 521

## Beschreibung

Der Anmeldungsgegenstand betrifft Anordnung zur Programmierung eines programmierbaren Bausteins, bei der auf einer Baugruppe ein Boundary Scan Stecker (BSS), ein Prozessor (MP) und mindestens ein Programmierbarer Baustein (PLD1..PLD4) mittels Boundary Scan Verbindungen (TDI, TDO, TMS, TCK) zu einer Boundary Scan Kette verbindbar sind.

Um komplexe Schaltkreise 'on Board' (in eingebautem Zustand auf der Leiterplatte einer Baugruppe) testen zu können, wurde der Boundary Scan entwickelt und genormt (Schnittstellen-Standard JTAG). Hierzu gehören sowohl Prozessoren als auch PLD's (Programmable Logic Device). Die betreffenden Bausteine sind auf der Leiterplatte (Platine) zu einer Boundary Scan Kette zusammengeschaltet und können so über einen speziellen Stecker BSS (On Board Boundary Scan Stecker) zu Testzwecken angesprochen werden. Diese Boundary Scan Architektur wird zunehmend auch dazu verwendet, PLD's auf der Platine zu programmieren (die PLD's sind dazu fähig).

Die Programme in als PLDs (programmable logic devices) bezeichneten Integrierten Bausteinen, welche über die JTAG Schnittstelle (Boundary Scan) programmiert werden, können bislang nur in der Fertigung oder durch einen Service-Techniker aktualisiert (Update) werden.

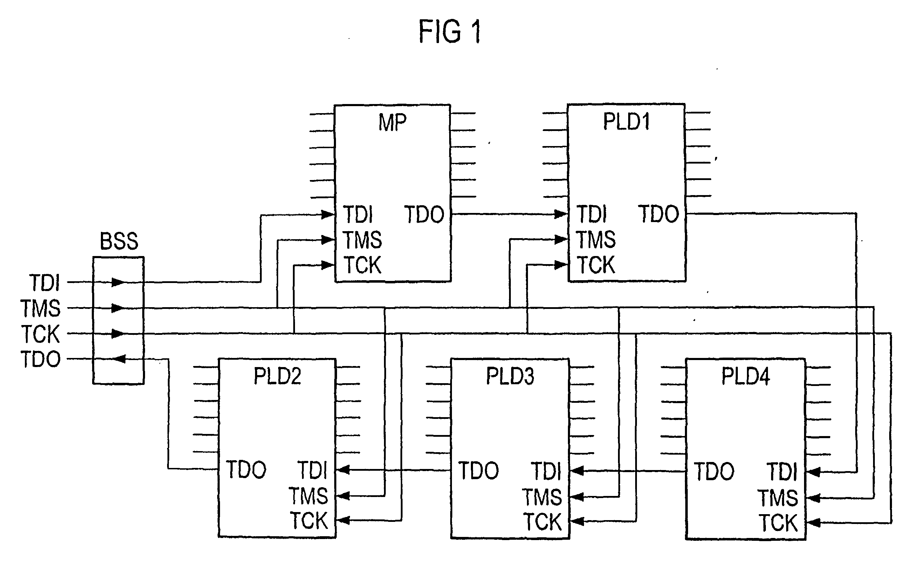

Im Falle eines notwendigen PLD Programmierungs-Updates muß ein Service-Techniker vor Ort die Baugruppe aus dem Baugruppenrahmen ziehen, in einen besonderen Adapter (Stromversorgung) stecken (zumindest muss sie funktional ausser Betrieb genommen werden) und über den Boundary Scan Stecker mit der Daten-Quelle für die Programmierung verbinden. Über den Boundary Scan Stecker BSS auf der Baugruppe können die PLD Bausteine in der Boundary Scan Kette (vgl. Fig 1) neu programmiert werden. Dies kann einen sehr hohen logistischen Aufwand bedeuten.

In komplexen Systemen, wie z. B. Vermittlungssystemen, sind dezentrale Einheiten über weite Strecken, teilweise über Satellit, mit einer zentralen Datenverarbeitungseinrichtung (Host) verbunden. Ein Update dieser Einheiten erfordert regelmäßig den Aufwand für die Anreise eines Service-Technikers.

Bislang gibt es nur die Möglichkeit programmierbare Bausteine, die auf RAM (Random Access Memory) Basis realisiert wurden (serielles ROM (Read Only Memory) zum Download der Programmierdaten auf der Baugruppe) über einen entsprechenden Prozessor zu programmieren.

Aus der US 5,640,521 ist eine Anordnung bekannt, bei der ein Primärer Bus-Master eine Vielzahl von Slave-Baugruppen, die jeweils einen fernbedienbaren (Remote) Bus-Master aufweisen, zur Durchführung eines Sebsttests ansteuern kann.

Aus der US 5,056,093 ist eine Anordnung bekannt, bei der ein Primärer Bus-Master auf einer von vielen Baugruppen einen fernbedienbaren (Remote) Bus-Master derart ansteuern kann, dass ein von dem Primären Bus-Master unabhängiges Testen einzelner Pfade auf der Baugruppe möglich ist.

Dem Anmeldungsgegenstand liegt das Problem zugrunde, eine Anordnung anzugeben, die es gestattet, einen Programmierbaren Baustein von der Ferne aus (remote) über dessen Boundary-Scan Einrichtung neu zu programmieren.

Das Problem wird durch einen Gegenstand mit den Merkmalen des Anspruchs 1 gelöst.

Die aktuellen Programmierfiles können von einer zentralen Ressource (z.B. einen zentralen Vermittlungsrechner) auf die verschiedenen Baugruppen geladen werden. Dieser Ladevorgang kann aus Sicherheitsgründen CRC oder Checksummen Überprüfungen enthalten.

Über entsprechende Kommandos kann von einer zentralen Ressource (z.B. einen zentralen Vermittlungsrechner) aus ein Update der PLD Bausteine erfolgen. Eine erfolgreiche Programmierung kann über eine Quittierung an die Zentrale mitgeteilt werden.

In der Fertigung ist der Prozessor weiterhin als JTAG Slave in die Boundary Scan Kette eingebunden und somit voll testfähig.

Vorteilhafte Weiterbildungen des Anmeldungsgegenstandes sind in den Unteransprüchen angegeben.

Der Anmeldungsgegenstand wird im folgenden als Ausführungsbeispiel in einem zum Verständnis erforderlichen Umfang anhand von Figuren näher erläutert. Dabei zeigen:
- Fig 1: eine herkömmliche Anordnung zur Überprüfung der Funktionsfähigkeit von Integrierten Bausteinen einer Baugruppe,
- Fig 2: eine anmeldungsgemäße Ausführungsform in einem Zustand, in dem der Prozessor in herkömmlicher Weise in der Boundary-Scan Kette eingeschaltet ist und
- Fig 3: die anmeldungsgemäße Ausführungsform in einem Zustand, in dem der Prozessor die Programmierbaren Bausteine über den den JTAG Port neu programmieren kann.

In den Figuren bezeichnen gleiche Bezeichnungen gleiche Elemente.

Der Anordnung in Fig 1 ist über einen auf der Baugruppe (onboard) angeordneten Boundary Scan-Stecker BSS nach Maßgabe eines allen Bausteinen zugeführten Taktsignals TCK über den Anschluss TDI eine Binärzeichenfolge zuführbar und über den Anschluss TDO eine Binärzeichenfolge auslesbar. Die Bausteine mögen durch einen Prozessor MP und die Programmierbaren Bausteine PLD 1..PLD 4 gegeben sein.

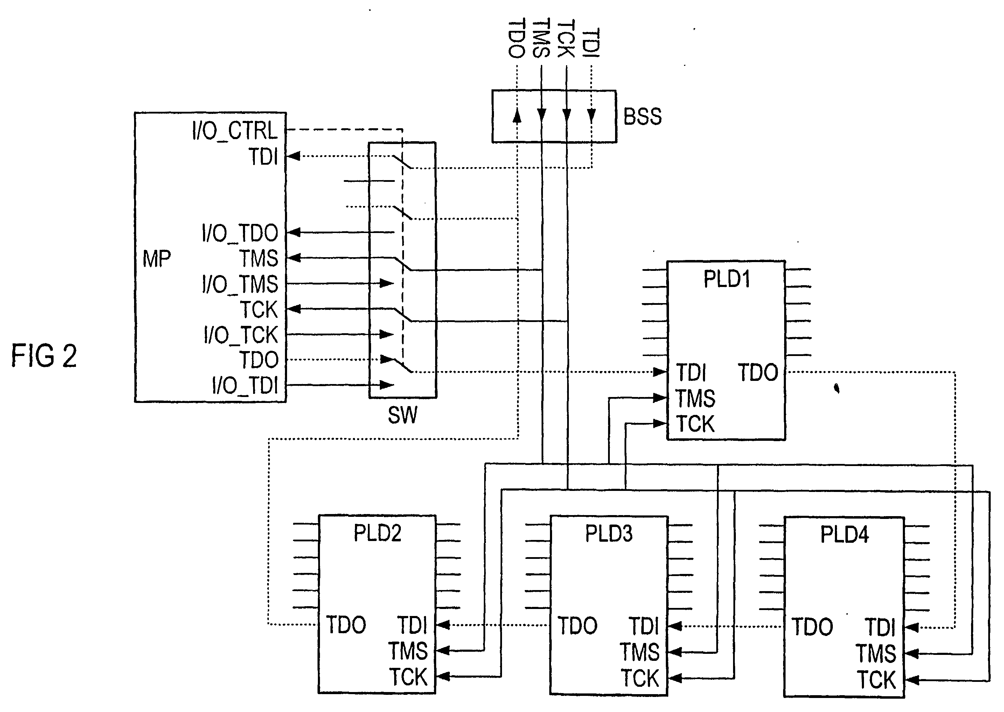

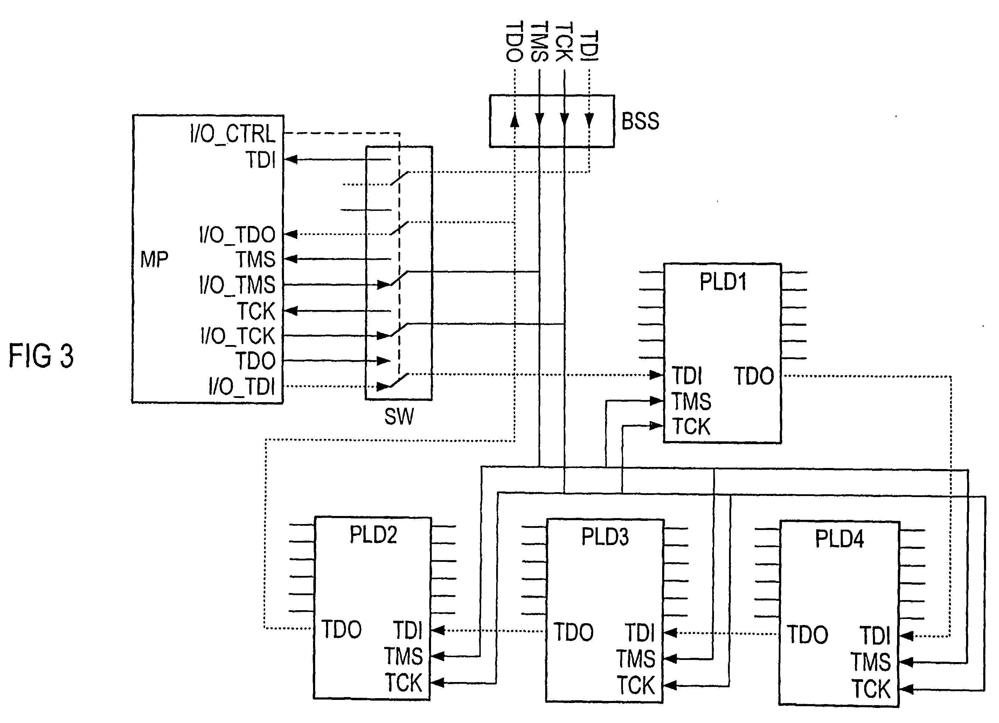

Die Figuren 2 und 3 zeigen eine anmeldungsgemäße Ausführungsform, bei der eine Umschalteeinrichtung SW (für: switch) in der in der Figur dargestellten Art und Weise mit den Anschlüssen des Boundary-Scan Steckers, den Anschlüssen des Prozessors und den Boundary-Scan Verbindungen der Programmierbaren Bausteine PLD 1..PLD 4 verbunden ist .

In der Figur 2 ist die anmeldungsgemäße Ausführungsform in einem als Boundary Scan Slave Mode bezeichneten Zustand dargestellt, bei der der Prozessor in herkömmlicher Weise in der Boundary-Scan Kette eingeschaltet ist. In dem Boundary Scan Slave Mode befindet sich der Prozessor als passives Mitglied in der BScan Kette. Die Programmierung erfolgt über den Boundary-Scan Stecker BSS.

In der Figur 3 ist die anmeldungsgemäße Ausführungsform in einem als Boundary Scan Master Mode bezeichneten Zustand dargestellt, bei der der Prozessor über ein an seinem Anschluß I/O_CTRL an die Umschalteeinrichtung SW abgegebenes Signal sie so steuert, dass er aus der Boundary-Scan Kette entfernt ist. Über I/O Pins (Eingangs-/Ausgangsanschlüsse) wird er nun derart in die Boundary Scan Kette eingebunden, daß er als Master den JTAG Port, umfassend die Boundary Scan Verbindungen TDI, TDO, TMS, TCK, nachbildet und steuert. Somit hat er die Möglichkeit, die PLD Bausteine der Baugruppe mittels eines implementierten Loaders zu programmieren. Dieser Loader besteht aus einem, in der Firmware des Prozessors eingebetteten Programm, das die Signale des JTAG Ports an freien I/O Ports des Prozessors nachbildet. Die Boot-Software des Prozessors mag um die Software des Loaders erweitert sein.

Der Prozessor bildet also an seinen mit dem JTAG-Port verbundenen I/O-Ports die On Board Boundary Scan Stecker-Schnittstelle nach.

Ein in einer dezentralen Einrichtung eines Vermittlungssystems angeordneter Prozessor ist über die Message-/Command-Schnittstelle vom zentralen Steuer- und Coordinierungs-Prozessor (Host) erreichbar, womit der Host über den Prozessor MP die Umschalteeinrichtung betätigen kann und somit Zugriff auf die Boundary Scan Kette der Baugruppe hat. Auf diese Weise kann aus dem Host neue Software in die PLD's geladen werden.

Ein in einer dezentralen Einrichtung eines Systems angeordneter Prozessor MP ist also anmeldungsgemäß dazu verwendbar, um einen Programmierbaren Baustein von einer zentralen Einrichtung des Systems aus neu zu programmieren (upzudaten).

Anmeldungsgemäss wird der Prozessor auf der Baugruppe, der ebenfalls Boundary Scan-fähig ist, als Programmierhilfe für die PLD's verwendet. Der Prozessor selbst ist 'Programmneutral', d.h. seine Boundary Scan Einrichtungen wird nur zu Testzwecken benötigt und benutzt.

## Patentansprüche

1. Anordnung zur Programmierung eines programmierbaren Bausteins bei der
- auf einer Baugruppe ein Boundary Scan Stecker (BSS), ein Prozessor (MP) und mindestens ein Programmierbarer Baustein (PLD1..PLD4) mittels Boundary Scan Verbindungen (TDI, TDO, TMS, TCK) zu einer Boundary Scan Kette verbindbar sind
- eine Umschalteinrichtung (SW) vorgesehen ist derart, dass der Prozessor als Sender und Empfänger für die Boundary Scan Verbindungen für den mindestens einen Programmierbaren Baustein in Wirkverbindung schaltbar ist,
- die Umschalteinrichtung nach Maßgabe eines von dem Prozessor abgegebenen Signals I/O_Ctrl steuerbar ist und
- die Anordnung eine dezentrale Einheit bildet und mit einer zentralen Einheit / Host in Wirkverbindung schaltbar ist, wobei eine Datei zur Aktualisierung des Programms in dem Programmierbaren Baustein von der zentralen Einheit zu der dezentralen Einheit übertragbar ist.

2. Anordnung nach Anspruch 1
**gekennzeichnet durch**
einen Prozessor, in dessen Firmware ein Loader zur Nachbildung der Signale eines JTAG Ports an seinen Anschlüssen implementiert ist.

## Claims

1. Arrangement for programming a programmable logic device, with which
- on a module a boundary scan connector (BSS), a microprocessor (MP) and at least one programmable logic device (PLD1..PLD4) are connected by means of boundary scan connections (TDI, TDO, TMS, TCK) into a boundary scan chain
- a switch (SW) is provided such that the processor can be switched into the operational connection as sender and recipient for the boundary scan connections for the at least one programmable logic device,
- the switch is controllable in accordance with a signal I/O Ctrl issued from the processor and
- the arrangement forms a decentralized unit and can be connected into an operational connection to a central unit/host, with a file for updating the program in the programmable logic device being able to be transmitted from the central unit to the decentralized unit

2. Arrangement according to Claim 1
**characterized by**
a processor, in the firmware of which a loader is implemented for emulating the signals of a JTAG port at its pins.

## Revendications

1. Dispositif pour la programmation d'un composant programmable, dans lequel
- un connecteur Boundary Scan (BSS), un processeur (MP) et au moins un composant programmable (PLD1...PLD4) peuvent être reliés pour former une chaîne de Boundary Scan au moyen de liaisons Boundary Scan (TDI, TDO, TMS, TCK) sur un bloc de composants,
- un dispositif de commutation (SW) est prévu de manière à ce que le processeur puisse être commuté en liaison active en tant qu'émetteur et récepteur pour les liaisons Boundary Scan pour le au moins un composant programmable,
- le dispositif de commutation peut être commandé en fonction d'un signal I/O_Ctrl délivré par le processeur et
- le dispositif forme une unité décentralisée et peut être commuté en liaison active avec une unité centrale/host, un fichier de mise à jour du programme dans le composant programmable pouvant être transmis de l'unité centrale à l'unité décentralisée.

2. Dispositif selon la revendication 1, **caractérisé par** un processeur dans la firmware duquel un loader destiné à simuler les signaux d'un port JTAG au niveau de ses bornes est implémenté.
